(19) Europäisches Patentamt
European Patent Office
Office européen des brevets

(11) Publication number: 0 049 997
B1

(12) **EUROPEAN PATENT SPECIFICATION**

(45) Date of publication of patent specification: **30.01.85**

(51) Int. Cl.[4]: **H 03 H 11/04,** H 03 H 11/12

(21) Application number: **81304633.1**

(22) Date of filing: **06.10.81**

(54) **Filter circuit suitable for being fabricated into integrated circuit.**

(30) Priority: **07.10.80 JP 139400/80**

(43) Date of publication of application:
**21.04.82 Bulletin 82/16**

(45) Publication of the grant of the patent:
**30.01.85 Bulletin 85/05**

(84) Designated Contracting States:
**AT DE FR GB IT**

(56) References cited:
**US-A-3 786 363**

**ELECTRONICS, vol. 53, no. 14, 19th June 1980, page 133, New York (USA); H.S. MALVAR: "Inverting amplifier flips filter's response curve".**

(73) Proprietor: **Hitachi, Ltd.**
**5-1, Marunouchi 1-chome**
**Chiyoda-ku Tokyo 100 (JP)**

(72) Inventor: **Nakagawa, Isao**
**1855-26, Higashiishikawa**
**Katsuta-shi (JP)**
Inventor: **Kondo, Kazuo**
**Fujimiryo 9-1-501 Aobacho**
**Katsuta-shi Ibaraki-ken (JP)**
Inventor: **Kudo, Mitsuru**
**9-1-501, Aobacho**
**Katsuta-shi (JP)**

(74) Representative: **Haigh, Charles Roy**
**J.A. KEMP & CO. 14 South Square Gray's Inn**
**London WC1R 5EU (GB)**

**EP 0 049 997 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a time-constant circuit, and more particularly to a time-constant circuit which can form a filter circuit suitable for being fabricated into an integrated circuit.

In general, inductive elements (L) cannot be integrated within the integrated circuit (IC). Therefore, the time-constant circuit for filters within the integrated circuit must be fabricated using capacitors (C) and resistors (R). A filter has been known comprising an active element and an RC time-constant circuit, and is generally called an active filter. The active filter can be fabricated into an integrated circuit in principle. However, due to the following practical problems, it is difficult to integrate filters within the integrated circuit. A time constant circuit is known which comprises

(a) an impedance converting circuit,

(b) an input circuit connected between a first input terminal and said impedance converting circuit, said input circuit having at least a series connected impedance element, and

(c) a further impedance element for feeding back the output of said impedance converting circuit to said input circuit, one of said impedance elements being a resistor and the other a capacitor.

Fig. 1 is a schematic diagram illustrating an example of a 2nd order low pass filter (hereinafter referred to as LPF) formed by an active filter, where an impedance converter 3 has a sufficiently high input impedance and a sufficiently low output impedance with the voltage gain of unity. Such a filter is, for example, described in "Design of an Active Amplifier" by T. Yanagisawa and I. Kanemitsu, Fig. 1.3 on page 4 (Dec 1973, Sanpo Publications Inc.). The transfer function $H(\omega)$ of the 2nd order LPF can be expressed as follows.

$$H(\omega) = \frac{\dfrac{1}{R_1R_2C_1C_2}}{(j\omega)^2 + (j\omega)\left(\dfrac{1}{R_1C_1} + \dfrac{1}{R_2C_1}\right) + \dfrac{1}{R_1R_2C_1C_2}} \qquad (1)$$

For the circuit of Fig. 1, the resonance frequency $\omega o$ and the value Q which represents the quality factor of the circuit are expressed as follows.

$$\omega o = \frac{1}{\sqrt{R_1C_1 \cdot R_2C_2}} \qquad (2)$$

$$Q = \frac{1}{\sqrt{\dfrac{R_2C_2}{R_1C_1}} + \sqrt{\dfrac{R_1C_2}{R_2C_1}}} \qquad (3)$$

Generally, circuit elements of the same type within an integrated circuit are fabricated simultaneously, resulting in a strong correlation in the characteristic values among each circuit element. Thus, the resistance value ratio and the capacitance value ratio can be made substantially constant. However, the accuracy of each absolute value is not so good. For example, whereas the absolute value accuracy of the resistance is about ±15% and that of the capacitance is about ±12%, the accuracy of the resistance value ratio and the capacitance value ratio can be made approximately ±1% and ±0.1%, respectively. Accordingly, the spread of the value of Q which is determined by the resistance value ratio and the capacitance value ratio can be made small without difficulty, whereas the accuracy of the resonance frequency, which is determined by the absolute value of the resistance and capacitance, ranges approximately ±20%. The resonance frequency $\omega o$ is a very important parameter for determining the cut-off frequency of the LPF , and it is hardly suitable for the practical use if there can be as much as ±20% variation in the resonance frequency.

Therefore, all of the resistors and capacitors have had to be provided outside of the integrated circuit to implement such a filter.

A low-order filter such as 2nd order may meet the requirement in this arrangement; however, filters of higher order are often demanded. In that case, a high order filter is made by combination of 2nd order filters, and the arrangement of the external resistors and capacitors not only causes an increase in the number of circuit components but necessitates many IC pins. Thus, it has been considered that the filter circuit is not suitable for being fabricated into an integrated circuit.

It is an object of the present invention to provide a filter circuit which is suitable for being fabricated into an integrated circuit including elements for determining the time-constant, and requires a lower number of pins and peripheral circuit components. According to the present invention, there is provided a time-constant circuit including elements for determining a time-constant comprising:

(a) an impedance converting circuit,

(b) an input circuit connected between a first input terminal and said impedance converting circuit, said input circuit having at least a series connected impedance element, and

(c) a further impedance element for feeding back the output of said impedance converting circuit to said imput circuit, one of said impedance elements being a resistor and the other a capacitor, characterized in that said time-constant circuit capable of being fabricated into an integrated circuit further comprises:

(d) a variable gain differential amplifier with its one input connected to the output of said impedance converting circuit and another input connected to a second input terminal, and with its gain being variable by an external means; and

(e) an adder circuit for adding a signal input via said second input terminal and an output signal from said variable gain differential amplifier; and wherein the capacitive element is provided between the output of said adder circuit and the input of said impedance converting circuit, and said input circuit has the resistive element connected between the first input terminal and the input of said impedance converting circuit.

A second aspect of the invention is characterized in that said filter circuit further comprises:

first and second time-constant circuits which each comprise an impedance converting circuit and

a variable gain differential amplifier with its one input connected to the output of said impedance converting circuit and its another input connected to a second input terminal and with its gain being variable by an external means, said input circuit being comprised of the resistive element connected between the first input terminal and the input of said impedance converting circuit, and at least the first time constant circuit comprising an adder circuit for adding a signal input via said second input terminal and an output signal from said variable gain differential amplifier, the capacitive element of the first time constant circuit being connected between the input of said impedance converting circuit and the output of said adder circuit, the first and second time constant circuits being connected in cascade with a feedback loop from an output of the second time constant circuit to an input of the first time constant circuit.

Other, optional features of the invention are defined in the sub-claims.

The above and other features and advantages of the present invention will become more fully apparent from the following detailed description of preferred embodiments thereof taken in conjunction with the accompanying drawings, in which:

Fig. 1 shows an example of the conventional active filter circuit;

Fig. 2 is a block diagram exemplifying the time-constant circuit which is the primary block of the filter circuit according to the present invention;

Fig. 3 shows an equivalent circuit diagram of the circuit shown in Fig. 2;

Fig. 4 is a block diagram showing one embodiment of the filter circuit according to the present invention;

Fig. 5 shows an equivalent circuit diagram of the circuit shown in Fig. 4;

Fig. 6 is a schematic diagram showing an example of a specific circuit in accordance with the circuit shown in Fig. 4;

Fig. 7 is a block diagram showing another embodiment of the present invention; and

Fig. 8 is a block diagram showing still another embodiment of the present invention.

The invention will now be described by way of embodiment with reference to the drawings. Fig. 2 is a block diagram showing an example of the time-constant circuit which is the primary block of the present invention. The circuit includes a first input terminal 4 for the time-constant circuit, an output terminal 5, a second input terminal 6, an impedance converter 3 having a voltage gain of unity, a variable gain differential amplifier 7, the gain of which varies in the range from 0 to 1, an adder circuit 8, a capacitor 9, and a resistor 10.

The capacitor 9 has the value of $C_3$ and the resistor 10 has the value of $R_3$. Assuming that the gain of the variable gain differential amplifier 7 is k, the transfer function $H_1(\omega)$ seen from the input terminal 4 to the output terminal 5 with the input terminal 6 being grounded can be expressed as:

$$H_1(\omega) = \frac{1}{1 + j\omega C_3(1 + k)R_3} \qquad (4)$$

The transfer function $H_2(\omega)$ seen from the input terminal 6 to the output terminal 5 with the input terminal 4 being grounded can be expressed as:

$$H_2(\omega) = \frac{j\omega C_3(1+k)R_3}{1+j\omega C_3(1+k)R_3} \quad (5)$$

Thus, the circuit of Fig. 2 is equivalent to the time-constant circuit shown in Fig. 3, provided:

$$R_4 = R_3 \quad (6)$$

and

$$C_4 = (1+k)C_3 \quad (7)$$

Since the gain k can be varied in the range from 0 to 1, the value of $C_4$ can vary in the range from $C_3$ to $2C_3$. That is, the value of $C_4$ can vary in the range from −33% to +33% relative to the value at $k = 1/2$. As described earlier, the spread of the time constant created by a capacitor and a resistor fabricated within the integrated circuit is in the range of ±20%, and thus can be compensated by this circuit arrangement.

Fig. 4 shows an embodiment of the present invention where two of the time-constant circuits shown in Fig. 2 are combined to constitute a 2nd order LPF, which includes an input therminal 11 for the 2nd order LPF, an output terminal 12 for the 2nd order LPF, a first time-constant circuit 13, and a second time-constant circuit 14. Variable gain differential amplifiers 7 and 7′ in the time-constant circuits 13 and 14, respectively, have an identical gain of k. By use of the equivalent circuit shown in Fig. 3, the two time-constant circuit in Fig. 4 can be transformed into a circuit as shown in Fig. 5.

Herein, the values of $R_7$, $C_7$, $R_8$, $C_8$ in Fig. 5 are in the following relation to the value $R_5$ of the resistor 10 and the value $C_5$ of the capacitor 9 in the first time-constant circuit 13 and the value $R_6$ of the resistor 10′ and the value $C_6$ of the capacitor 9′ in the second time-constant circuit 14:

$$R_7 = R_5 \quad (8)$$

$$C_7 = (1+k)C_5 \quad (9)$$

$$R_8 = R_6 \quad (10)$$

$$C_8 = (1+k)C_6 \quad (11)$$

The transfer function $H_3(\omega)$ of the 2nd order LPF shown in Fig. 5 can be expressed in the following equation.

$$H_3(\omega) = \frac{\frac{1}{C_7R_7C_8R_8}}{(j\omega)^2 + (j\omega)\frac{1}{C_8R_8} + \frac{1}{C_7R_7C_8R_8}} \quad (12)$$

Accordingly, the value of Q and the resonance frequency $\omega o$ of the circuit of Fig. 5 are obtained as follows.

$$Q = \sqrt{\frac{C_7R_7}{C_8R_8}} \quad (13)$$

$$\omega o = \frac{1}{\sqrt{C_7R_7C_8R_8}} \quad (14)$$

That is, the value of Q and the resonance frequency $\omega o$ of the circuit of Fig. 4 can be expressed as follows.

$$Q = \sqrt{\frac{(1+k)\,C_5R_5}{(1+k)\,C_6R_6}} = \sqrt{\frac{C_5R_5}{C_6R_6}} \qquad (15)$$

$$\omega o = \frac{1}{\sqrt{(1+k)\,C_5R_5 \times (1+k)\,C_6R_6}} = \frac{1}{(1+k)\sqrt{C_5R_5C_6R_6}} \qquad (16)$$

As can be seen from equations (15) and (16), the value of Q is not varied by changing the gain k, and thus the resonance frequency $\omega o$ of the circuit of Fig. 4 can be varied without affecting the value of Q. Consequently, the spread of the resonance frequency due to the spread of the absolute values of capacitors and resistors can be compensated by varying the gain k of the variable gain differential amplifiers 7 and 7′. Moreover, the two variable gain differential amplifiers 7 and 7′ have exactly the same gain, allowing the control with a common DC voltage.

LPFs of much higher order can be realized by combination of the above 2nd order LPFs. As can be seen from the nature of the IC fabricating process, when high order LPFs are fabricated within an integrated circuit, the absolute values of resistors and capacitors of 2nd order LPFs have the same trend of spread. That is, they spread identically from the desired time constant and this allows all the variable gain differential amplifiers to have the same gain, which can be controlled with a single DC voltage. In addition, a plurality of filters fabricated within an integrated circuit have the same spread of time constant from the desired time constant, thereby allowing their adjustment for the desired time constant with a single DC voltage.

Fig. 6 shows an example of the practical circuit for the embodiment shown in Fig. 4. In Fig. 6, resistor $R_5$ and capacitor $C_5$ correspond to the resistor 10 and the capacitor 9 of the first time-constant circuit 13 shown in Fig. 4, and resistor $R_6$ and capacitor $C_6$ correspond to the resistor 10′ and the capacitor 9′ of the second time-constant circuit 14 shown in Fig. 4. Darlington-coupled transistors $Q_1$ and $Q_2$ constitute the impedance converter 3 in the first time-constant circuit 13 shown in Fig. 4, and differential transistor pairs $Q_3$ and $Q_4$, and $Q_7$ and $Q_8$ constitute the variable gain differential amplifier 7 in the first time-constant circuit 13. Transistors $Q_5$ and $Q_6$ constitute the impedance converter 3′ in the second time-constant circuit 14, and differential transistor pairs $Q_9$ and $Q_{10}$, and $Q_{11}$ and $Q_{12}$ constitute the variable gain differential amplifier 7′ in the second time-constant circuit 14. Reference numbers 20 and 22 denote pins on the integrated circuit, 21 is an external variable resistor for controlling the gain of the variable gain amplifier, $C_9$ is an external signal smoothing capacitor, and $Q_{15}$ to $Q_{20}$ are transistors for the constant current sources.

As can be seen from Fig. 6, the variable gain differential amplifiers 7 and 7′ are achieved by the differential pairs $Q_7$ and $Q_8$, and $Q_9$ and $Q_{10}$ in a current switching mode. To make the circuit simple, the transistors $Q_{11}$ and $Q_{12}$ constituting the variable gain differential amplifier 7′ together with transistors $Q_9$ and $Q_{10}$ in the second time-constant circuit 14 are adapted to serve also for a part of an adder circuit 8 in the first time-constant circuit 13 so that the collector current of the transistor $Q_{12}$ is added to the collector current of the transistor $Q_7$.

As shown in Fig. 4, the second input terminal 6′ which is one input of the adder circuit 8′ in the second time-constant circuit 14 is grounded, thus the adder circuit 8′ simply buffers the input of the variable gain differential amplifier 7′. Also to make the circuit simple, the adder circuit 8′ is omitted from the circuit of Fig. 6, and the collector current of the transistor $Q_9$ is converted into a voltage through a resistor $R_{17}$ and outputted through a low impedance buffer transistor $Q_{13}$. Although some circuit components are shared or omitted for simplyfying the circuit, it does not mean the alteration of the concept, but it is easily possible to consider the circuit in the original arrangement. In order to make the adder circuit 8 have a gain of unity for each input and to vary the gain of the variable gain differential amplifiers 7 and 7′ in the range from 0 to 1, resistors $R_{12}$, $R_{13}$, $R_{14}$, $R_{17}$, $R_{20}$, $R_{21}$, $R_{26}$, and $R_{29}$ should be set, for example, to meet the following conditions.

$$R_{12} = R_{17} = R_{13} + R_{14} + 2Re \qquad (17)$$

$$R_{13} = R_{14} = R_{20} = R_{21} \qquad (18)$$

$$R_{26} = R_{29} \qquad (19)$$

where Re is the emitter operating resistance of the transistors $Q_3$, $Q_4$, $Q_{11}$ and $Q_{12}$.

Fig. 7 shows an embodiment of the present invention for constructing a 2nd order high-pass filter (HPF) circuit. The transfer function $H_4(\omega)$, the value of Q and the resonance frequency $\omega o$ of the HPF circuit of Fig. 7 are expressed as follows.

$$H_4(\omega) = \frac{(j\omega)^2}{(j\omega)^2 + (j\omega)\frac{1}{(1+k)C_6R_6} + \frac{1}{(1+k)^2C_5R_5C_6R_6}} \qquad (20)$$

$$Q = \sqrt{\frac{C_6R_6}{C_5R_5}} \qquad (21)$$

$$\omega o = \frac{1}{(1+k)\sqrt{C_5R_5C_6R_6}} \qquad (22)$$

In Fig. 7, reference number 15 denotes an input terminal and 16 is an output terminal.

Fig. 8 shows an embodiment of the present invention for constructing a 2nd order band-pass filter (BPF). The transfer function $H_5(\omega)$, the value of Q and the resonance frequency $\omega o$ of the BPF circuit of Fig. 8 are expressed as follows.

$$H_5(\omega) = \frac{(j\omega)\frac{1}{(1+k)\ C_5R_5}}{(j\omega)^2 + (j\omega)\frac{1}{(1+k)C_6R_6} + \frac{1}{(1+k)^2C_5R_5C_6R_6}} \qquad (23)$$

$$Q = \sqrt{\frac{C_6R_6}{C_5R_5}} \qquad (24)$$

(25)

In this case, the value of the resistor 10 in the first time-constant circuit 13 should be made as $2R_5$, twice the magnitude in the cases of the LPF and HPF, and the resistance $R_9$ should be set to meet $R_9 = 2R_5$. In Fig. 8, reference number 17 denotes an input terminal, 18 is an output terminal, 19 is an amplifier, and 20 is an input terminal.

Although the 2nd order BPF needs an additional amplifier having a gain of two and a resistor, it can be constructed basically by combination of two time-constant circuits.

It is well known in the art that any higher order filter can be composed by combination of a 2nd order LPF, 2nd order HPF, 2nd order BPF, 1st order LPF and a 1st order HPF.

Accordingly, the present invention easily provides a filter having desired characteristics by combining a 2nd order LPF, HPF and BPF, and a 1st order LPF and BPF as described in the foregoing embodiments.

One variant of the embodiment of Fig. 7 may differ from it in that (a) the first input terminal 4 of the first time-constant circuit 13 is connected to the output terminal 5′ of the second time-constant circuit (14), (b) the input signal is supplied to the second input terminal 6 instead of the first input terminal 4 of the first time-constant circuit 13, and the input terminal 4′ of the second time-constant circuit 14 is grounded and the second input terminal 6′ of the second time-constant circuit 14 is connected to the output terminal 5 of the first time-constant circuit 13. By comparison with Figures 3 and 5, it will be appreciated that the equivalent circuit of this variant will correspond generally with that of Figure 5, but with capacitors substituted for resistors and vice versa, and with the input being terminal 15, and the output terminal 16.

**Claims**

1. A time-constant circuit including elements for determining a time-constant comprising:

(a) an impedance converting circuit (3),

(b) an input circuit connected between a first input terminal (4) and said impedance converting circuit (3), said input circuit having at least a series connected inpedance element (10), and

(c) a further impedance element (9) for feeding back the output of said impedance converting circuit to said input circuit, one of said impedance elements being a resistor and the other a capacitor, characterized in that said time-constant circuit capable of being fabricated into an integrated circuit further comprises:

(d) a variable gain differential amplifier (7) with its one input connected to the output of said impedance converting circuit (3) and another input connected to a second input terminal (6), and with its gain being variable by an external means; and

(e) an adder circuit (8) for adding a signal input via said second input terminal (6) and an output signal from said variable gain differential amplifier (7); and wherein the capacitive element (9) is provided between the output of said adder circuit (8) and the input of said impedance converting circuit (3), and said input circuit has the resistive element (10) connected between the first input terminal (4) and the input of said impedance converting circuit (3).

2. A filter circuit suitable for being fabricated into an integrated circuit comprising:

an impedance converting circuit (3),

an input circuit connected between a first input terminal (4) and said impedance converting circuit (3), said input circuit having at least a series connected impedance element (10), and a further impedance element (9) for feeding back the output of said impedance converting circuit (3) to said input circuit, one of the impedance elements being a resistor and the other a capacitor, characterized in that said filter circuit further comprises: first and second time-constant circuits (13, 14) which each comprise an impedance converting circuit (3, 3′) and a variable gain differential amplifier (7, 7′) with its one input connected to the output of said impedance converting circuit (3, 3′) and its other input connected to a second input terminal (6, 6′), and with its gain being variable by an external means, said input circuit being comprised of the resistive element (10, 10′) connected between the first input terminal (4, 4′) and the input of said impedance converting circuit (3, 3′), and at least the first time constant circuit comprising an adder circuit (8) for adding a signal input via said second input terminal (6) and an output signal from said variable gain differential amplifier (7), the capacitive element (9) of the first time constant circuit being connected between the input of said impedance converting circuit (3) and the output of said adder circuit (8), the first and second time constant circuits being connected in cascade with a feedback loop from an output of the second time constant circuit to an input of the first time constant circuit.

3. A circuit according to claim 2 wherein an output from said output terminal of said first time-constant circuit (13) is supplied to said first input terminal of said second time-constant circuit (14), an output from said output terminal (5′) of said second time-constant circuit (14) is supplied to said second input terminal (6) of said first time-constant circuit (13) and said second input terminal (6′) of said second time-constant circuit (14) is grounded.

4. A filter circuit suitable for being fabricated into an integrated circuit according to claim 2 characterized in that an output from said output terminal (5) of said first time-constant circuit (13) is supplied to said second input terminal (6′) of said second time-constant circuit (14), an output from said input terminal (5′) of said second time-constant circuit (14) is supplied to said first input terminal (4) of said first time-constant circuit (13), and said first input terminal (6′) of said second time-constant circuit (14) is grounded.

5. A filter circuit suitable for being fabricated into an integrated circuit according to claim 2 characterized in that an output from said output terminal (5) of said first time-constant circuit (13) is supplied to said second input terminal (6′) of said second time-constant circuit (14) instead of to said first input terminal, an output from said output terminal (5′) of said second time-constant circuit (14) is supplied through an amplifying circuit (19) and serial-connected resistive elements ($R_9$) to the input of said impedance converting circuit (3) in said first time-constant circuit (13) instead of to said second input terminal of said first time-constant circuit, and

said second input terminal (6) of said first time-constant circuit (13) and said first input terminal (4′) instead of said second input terminal (6′) of said second time-constant circuit (14) are grounded.

6. A filter circuit as claimed in any of claims 1 to 4 further comprising a current switching means formed of a differential transistor pair ($Q_3$, $Q_4$; $Q_7$, $Q_8$) for controlling the gain of said variable gain differential amplifier (3).

7. A filter circuit as claimed in claim 2 or claim 5, wherein said first or second time-constant circuit (14) with its second terminal (6′) grounded is constructed such that said capacitive element (9′) is connected directly between the output of said variable gain differential amplifier (7′) and the input of said impedance converting circuit (3′) in omission of said adder circuit (8′).

**Revendications**

1. Circuit à constante de temps contenant des éléments servant à déterminer une constante de temps, comprenant:

a) un circuit convertisseur d'impédance (3),

b) un circuit d'entrée raccordé entre une première borne d'entrée (4) et ledit circuit convertisseur d'impédance (3), ledit circuit d'entrée possédant au moins un élément (10) formant impédance branché en série, et

c) un autre élément formant impédance (9) servant à relier par réaction la sortie dudit circuit convertisseur d'impédance audit circuit d'entrée, l'un desdits éléments formant impédance branché résistance et l'autre un condensateur,

caractérisé en ce que ledit circuit à constante de temps apte à être fabriqué sous la forme d'un circuit intégré comporte en outre:

d) un amplificateur différential (16) à gain variable, dont une entrée est raccordée à la sortie dudit circuit convertisseur d'impédance (3) et dont une autre entrée est raccordée à une seconde borne d'entrée (6), et dont le gain est modifiable à l'aide d'un dispositif extérieur; et

e) un circuit additionneur (8) servant à additionner un signal introduit par l'intermédiaire de ladite seconde borne d'entrée (6) et un signal de sortie fourni par ledit amplificateur différential à gain variable (7), l'élément capacitif (9) étant prévu entre la sortie dudit circuit additionneur (8) et l'entrée dudit circuit convertisseur d'impédance (3), et l'élément résistif (10) dudit circuit d'entrée étant raccordé entre la première borne d'entrée (4), et l'entrée dudit circuit convertisseur d'impédance (3).

2. Circuit de filtre apte à être fabriqué sous la forme d'un circuit intégré, comprenant:

un circuit convertisseur d'impédance (3),

un circuit d'entrée monté entre une première borne d'entrée (4) et ledit circuit convertisseur d'impédance (3), ledit circuit d'entrée possédant au moins un élément formant impédance (10) branché en série, et un autre élément formant impédance (9) servant à relier par réaction la sortie dudit circuit convertisseur d'impédance (3) audit circuit d'entrée, l'un des éléments formant impédance étant une résistance et l'autre un condensateur, caractérisé en ce que ledit circuit de filtre comporte en outre: des premier et second circuits à constante de temps (13, 14), comportant chacun un circuit convertisseur d'impédance (3, 3′) et un amplificateur différentiel à gain variable (7, 7′), dont une entrée est raccordée à la sortie dudit circuit convertisseur d'impédance (3, 3′) et dont l'autre entrée est raccordée à une seconde borne d'entrée (6, 6′) et dont le gain est modifiable à l'aide d'un dispositif extérieur, ledit circuit d'entrée étant constitué par l'élément résistif (10, 10′) branché entre la première borne d'entrée (4, 4′) et l'entrée dudit circuit convertisseur d'impédance (3, 3′), et au moins le premier circuit à constante de temps comprenant un circuit additionneur (8) servant à additionner un signal introduit par l'intermédiaire de ladite seconde borne d'entrée (6) et un signal de sortie provenant dudit amplificateur différentiel à gain variable (7), l'élément capacitif (9) du premier circuit à constante de temps étant monté entre l'entrée dudit circuit convertisseur d'impédance (3) et la sortie dudit circuit additionneur (8), et les premier et second circuits à constante de temps étant branchés en cascade avec une boucle de réaction reliant une sortie du second circuit à constante de temps à une entrée du premier circuit à constante de temps.

3. Circuit selon la revendication 2, dans lequel un signal de sortie de ladite borne de sortie dudit premier circuit à constante de temps (13) est envoyé à ladite première borne dudit second circuit à constante de temps (14), qu'un signal de sortie provenant de ladite borne de sortie (5′) dudit second circuit à constante de temps (14) est envoyé à ladite seconde borne d'entrée (6) dudit premier circuit à constante de temps (13) et que ladite seconde borne d'entrée (6′) dudit second circuit à constante de temps (14) est raccordée à la masse.

4. Circuit de filtre apte à être fabriqué sous la forme d'un circuit intégré, selon la revendication 2, caractérisé en ce qu'un signal de sortie provenant de ladite borne de sortie (5) dudit premier circuit à constante de temps (13) est envoyé à ladite seconde borne d'entrée (6′) dudit second circuit à constante de temps (14), qu'un signal de sortie provenant de ladite borne de sortie (5′) dudit second circuit à constante de temps (14) est envoyé à ladite première borne d'entrée (4) dudit premier circuit à constante de temps (13), et que ladite première borne d'entrée (6′) dudit second circuit à constante de temps (14) est raccordée à la masse.

5. Circuit de filtre apte à être fabriqué sous la forme d'un circuit intégré, selon la revendication 2, caractérisé en ce qu'un signal de sortie provenant de ladite borne de sortie (5) dudit premier circuit à constante de temps (13) est envoyé à ladite seconde borne d'entrée (6′) dudit second circuit à constante de temps (14) au lieu d'être envoyé à ladite première borne d'entrée, qu'un signal de sortie provenant de ladite borne de sortie (5′) dudit second circuit à constante de temps (14) est envoyé par l'intermédiaire d'un circuit amplificateur (19) et d'éléments résistifs ($R_9$) raccordés en série, à l'entrée dudit circuit convertisseur d'impédance (3) situé dans ledit premier circuit à constante de temps (13), au lieu d'être envoyé à ladite seconde borne d'entrée dudit premier circuit à constante de temps, et que la seconde borne d'entrée (6) dudit premier circuit à constante de temps (13) et ladite première borne d'entrée (4′), à la place de ladite seconde borne d'entrée (6′) dudit second circuit à constante de temps (14), sont raccordées à la masse.

6. Circuit de filtre suivant l'une quelconque des revendications 1 à 4, comportant en outre un dispositif de commutation de courant, constitué par un couple de transistors différentiels ($Q_3$, $Q_4$; $Q_7$, $Q_8$) servant à commander le gain dudit amplificateur différentiel à gain variable (3).

7. Circuit de filtre selon la revendication 2 ou 5, dans lequel ledit premier ou second circuit à constante de temps (14), dont la seconde borne d'entrée (6') est raccordée à la masse, est constitué de telle sorte que ledit élément capacitif (9') est raccordé directement entre la sortie dudit amplificateur différentiel à gain variable (7') et l'entrée dudit circuit convertisseur d'impédance (3'), tandis que ledit circuit additionneur (8') est supprimé.

**Patentansprüche**

1. Zeitkonstantenschaltung mit eine Zeitkonstante bestimmenden Schaltungselementen, umfassend:

a) eine Impedanzwandlerschaltung (3),

b) eine zwischen einer ersten Eingangsklemme (4) und der Impedanzwandlerschaltung (3) angeschlossene Eingansschaltung mit wenigstens einem in Reihe geschalteten Impedanzelement (10) und

c) ein weiteres Impendanzelement (9) im Rückkopplungsweg zwischen dem Ausgang der Impedanzwandlerschaltung und der Eingangschaltung, wobei eines der Impedanzelemente ein Widerstand und das andere ein Kondensator ist, dadurch gekennzeichnet, daß die für die Herstellung als integrierte Schaltung geeignete Zeitkonstantenschaltung weiters

d) einen Differenzverstärker (7) mit veränderbarer Verstärkung, dessen einer Eingang mit dem Ausgang der Impedanzwandlerschaltung (3) verbunden ist, dessen anderer Eingang mit einer zweiten Eingangsklemme (6) verbunden ist und dessen Verstärkung mittels einer äußeren Vorrichtung veränderbar ist, und

e) eine Summierschaltung (8) zum Addieren eines Eingangssignals von der zweiten Eingangsklemme (6) und eines Ausgangssignals vom Differenzverstärker (7) mit veränderbarer Verstärkung aufweist, wobei das kapazitive Element (9) zwischen dem Ausgang der Summierschaltung (8) und dem Eingang der Impedanzwandlerschaltung (3) vorgesehen ist und die Eingangsschaltung das Widerstandselement (10) zwischen der ersten Eingangsklemme (4) und dem Eingang der Impedanzwandlerschaltung (3) enthält.

2. Für die Herstellung als integrierte Schaltung geeignete Filterschaltung, umfassend: eine Impedanzwandlerschaltung (3), eine zwischen einer ersten Eingangsklemme (4) und der Impedanzwandlerschaltung (3) angeschlossene Eingangsschaltung mit wenigstens einem in Reihe geschalteten impedanzelement (10) und ein weiters Impedanzelement (9) im Rückkopplungsweg zwischen dem Ausgang der Impedanzwandlerschaltung (3) und der Eingangsschaltung, wobei eines der Impedanzelemente ein Widerstand und das andere ein Kondensator ist, dadurch gekennzeichnet, daß die Filterschaltung weiters erste und zweite Zeitkonstantenschaltungen (13, 14) mit je einer Impedanzwandlerschaltung (3, 3') und je einem Differenzverstärker (7, 7') mit veränderbarer Verstärkung aufweist, wobei ein Eingang jedes Differenzverstärkers (7, 7') mit dem Ausgang der Impedanzwandlerschaltung (3, 3') verbunden ist, der andere Eingang mit einer zweiten Eingangsklemme (6, 6') verbunden ist und die Verstärkung mittels einer äußeren Vorrichtung veränderbar ist, daß die Eingangsschaltung von dem zwischen der ersten Eingangsklemme (4, 4') und dem Eingang der Impedanzwandlerschaltung (3, 3') angeschlossenen Widerstandselement (10, 10') gebildet ist, daß wenigstens die erste Zeitkonstantenschaltung eine Summierschaltung (8) zum Addieren eines Eingangssignals von der zweiten Eingangsklemme (6) und eines Ausgangssignals vom Differenzverstärker (7) mit veränderbarer Verstärkung aufweist, wobei das kapazitive Element (9) der ersten Zeitkonstantenschaltung zwischen dem Eingang der Impedanzwandlerschaltung (3) und dem Ausgang der Summierschaltung (8) angeschlossen ist, und daß die erste und die zweite Zeitkonstantenschaltung in Kaskade geschaltet sind und eine Rückkopplungsschleife von einem Ausgang der zweiten Zeitkonstantenschaltung zu einem Eingang der ersten Zeitkonstantenschaltung vorgesehen ist.

3. Schaltung nach Anspruch 2, bei welcher ein Ausgangssignal vom Ausgang der ersten Zeitkonstantenschaltung (13) dem ersten Eingang der zweiten Zeitkonstantenschaltung (14) zugeführt ist, ein Ausgangssignal vom Ausgang (5') der zweiten Zeitkonstantenschaltung (14) dem zweiten Eingang (6) der ersten Zeitkonstantenschaltung (13) zugeführt ist und der zweite Eingang (6') der zweiten Zeitkonstantenschaltung (14) an Masse liegt.

4. Für die Herstellung als integriert Schaltung geeignete Filterschaltung nach Anspruch 2, dadurch gekennzeichnet, daß ein Ausgangssignal vom Ausgang der ersten Zeitkonstantenschaltung (13) dem zweiten Eingang (6') der zweiten Zeitkonstantenschaltung (14) zugeführt ist, ein Ausgangssignal vom Ausgang (5') der zweiten Zeitkonstantenschaltung (14) dem ersten Eingang (4) der ersten Zeitkonstantenschaltung (13) zugeführt ist, und der erste Eingang (6') der zweiten Zeitkonstantenschaltung (14) an Masse liegt.

5. Für die Herstellung als integrierte Schaltung geeignete Filterschaltung nach Anspruch 2, dadurch gekennzeichnet, daß ein Ausgangssignal vom Ausgang (5) der ersten Zeitkonstantenschaltung (13) statt dem ersten Eingang dem zweiten Eingang (6') der zweiten Zeitkonstantenschaltung (14) zugeführt ist, ein Ausgangssignal vom Ausgang (5') der zweiten Zeitkonstantenschaltung (14) statt dem zweiten Eingang der ersten Zeitkonstantenschaltung über eine Verstärkerschaltung (19) und in Reihe geschaltete Widerstandselemente ($R_8$) dem Eingang der Impedanzwandlerschaltung (3) in der ersten Zeitkonstantenschaltung (13) zugeführt ist, und der zweite Eingang (6) der ersten Zeitkonstantenschaltung (13) und statt des zweiten Einganges (6') der erste Eingang (4') der zweiten Zeitkonstantenschaltung (14) an Masse liegen.

6. Filterschaltung nach einem der Ansprüche 1 bis 4, welche weiters eine von einem DifferenzverstärkerTransistorpaar ($Q_3$, $Q_4$; $Q_7$, $Q_8$ gebildete Stromumschaltvorrichtung zum Steuern der Verstärkung des Differenzverstärkers (3) mit veränderbarer Verstärkung aufweist.

7. Filterschaltung nach Anspruch 2 oder 5, bei welcher die erste oder die zweite Zeitkonstantenschaltung (14) mit an Masse liegendem zweiten Eingang (6') so ausgebildet ist, daß das kapazitive Element (9') unmittelbar zwischen dem Ausgang des Differenzverstärkers (7') mit veränderbarer Verstärkung und dem Eingang der Impedanzwandlerschaltung (3') unter Weglassung der Summierschaltung (8') angeschlossen ist.

FIG. 1

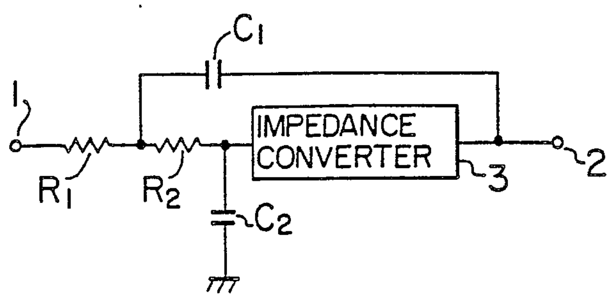


FIG. 2

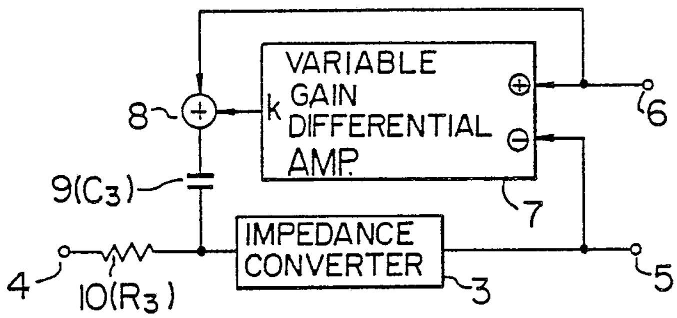


FIG. 3

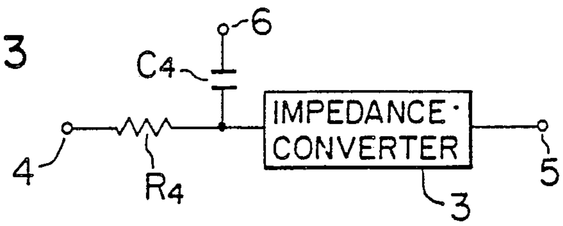


FIG. 4

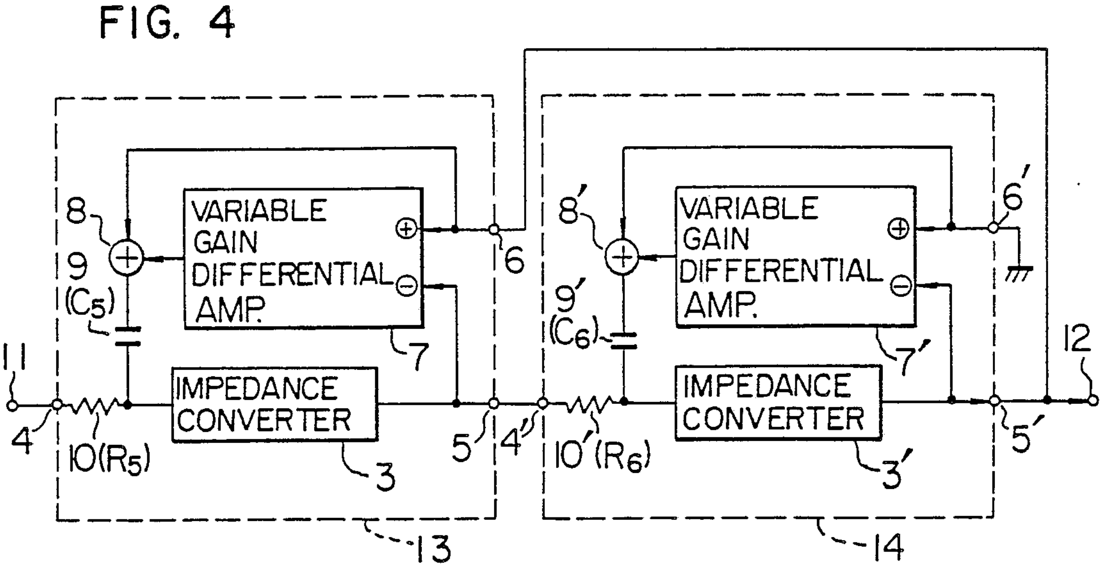

FIG. 5

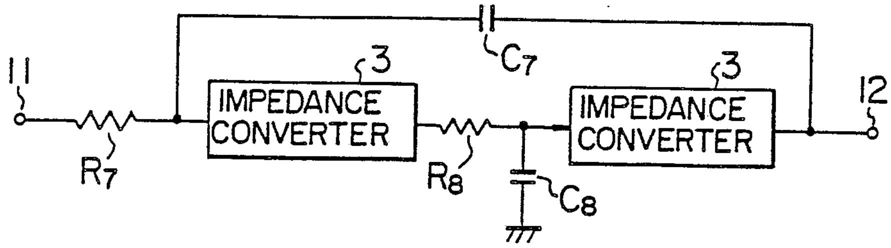


FIG. 7

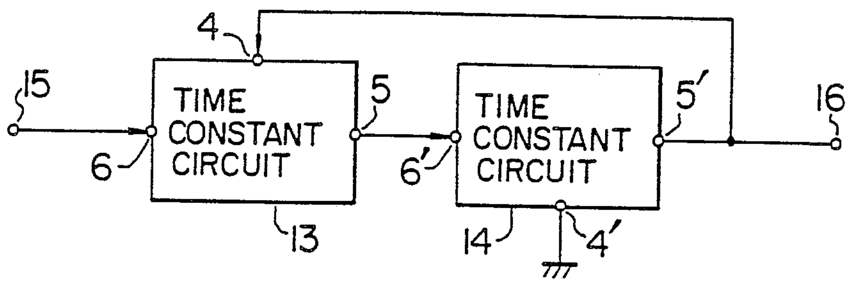


FIG. 8

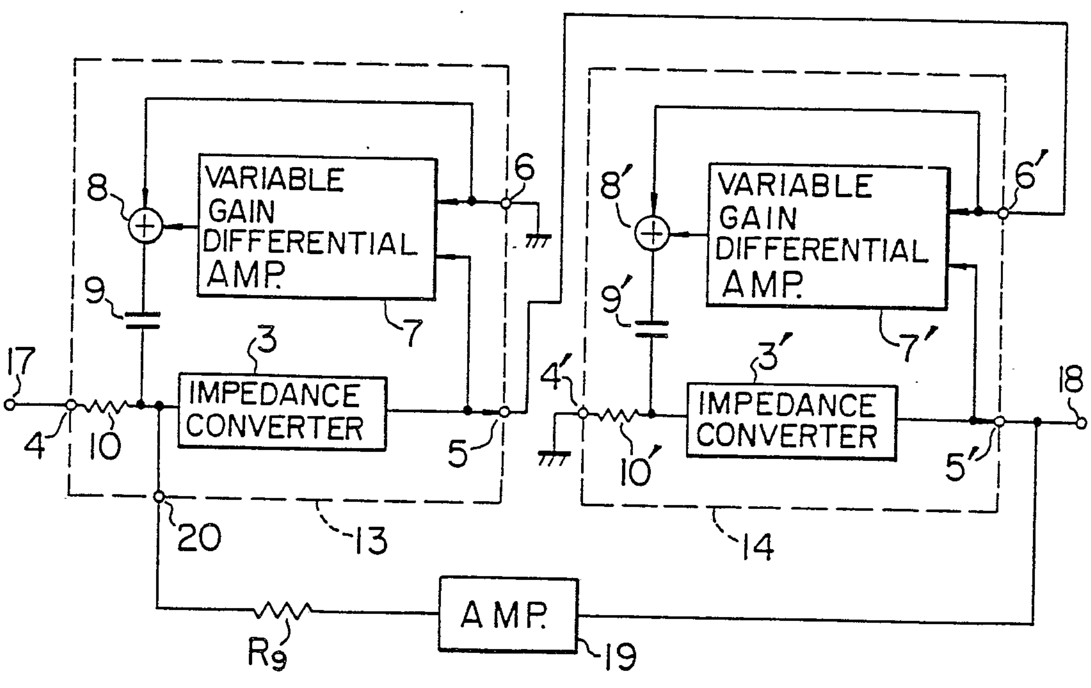

FIG. 6

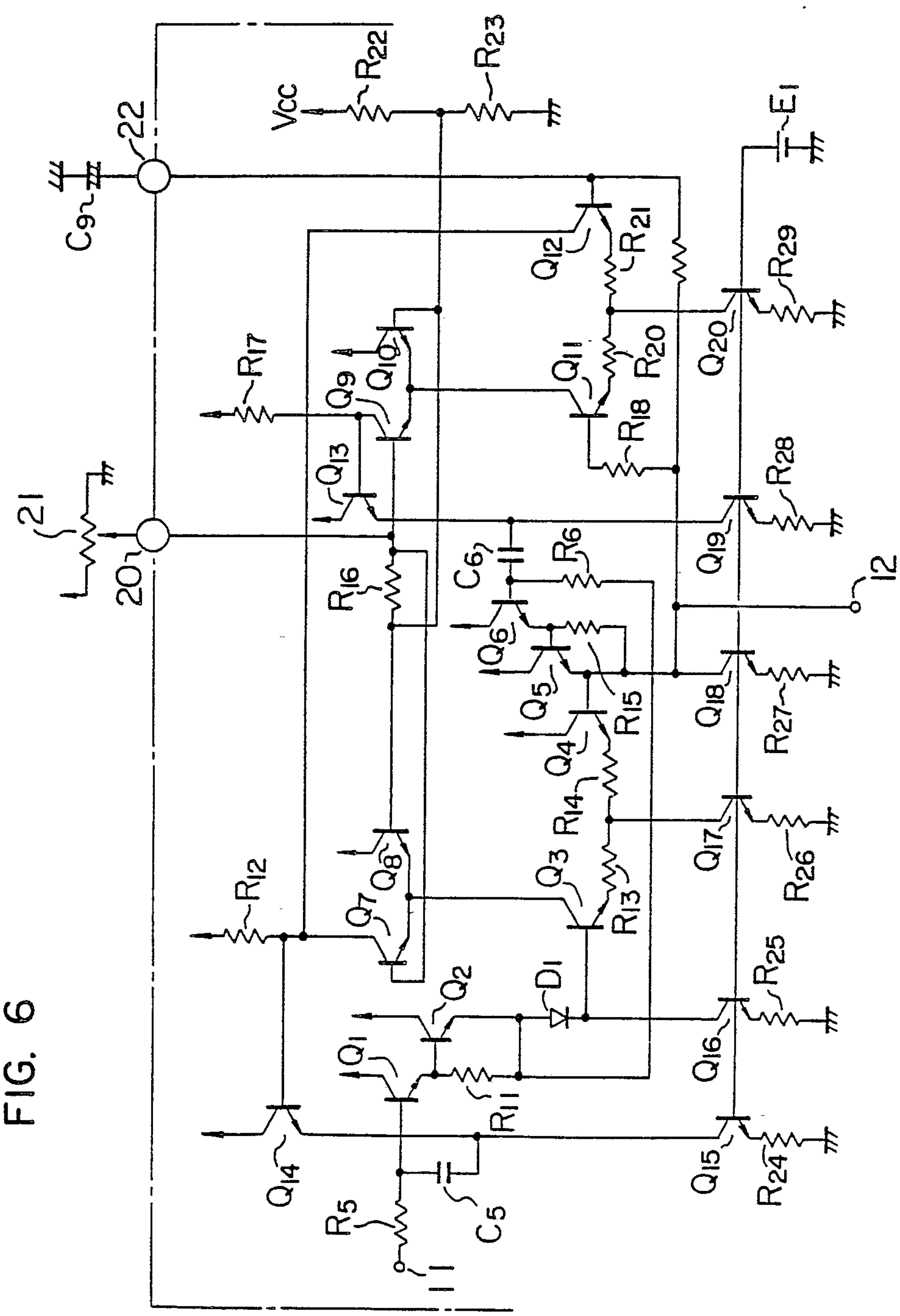
C9
22
Vcc
R22
R23
E1
21
20
R17
Q9
Q10
Q11
Q12
R21
R29
R20
Q20
R18
R28
Q13
Q19
C6
R6
12
R16
Q6
Q5
Q18
R15
R27
Q4
R14
Q17
R26
R12
Q7
Q8
Q3
R13
R25
D1
Q2
Q1
Q16
R11
Q14
Q15
R24
C5
R5
11